# EUROPÄISCHE PATENTSCHRIFT

(11) **EP 2 868 168 B1**
(45) Veröffentlichungstag und Bekanntmachung des Hinweises auf die Patenterteilung: **11.08.2021**
(21) Anmeldenummer: 13730114.9
(22) Anmeldetag: 12.06.2013
(51) Int. Cl.: H05K 1/02, H05K 1/16, H05K 3/00, H05K 5/00

(54) **LEITERPLATTE, STEUERGERÄT, EINRICHTUNG MIT EINER VOM STEUERGERÄT STEUERBAREN VORRICHTUNG UND KRAFTFAHRZEUG DAMIT SOWIE VERFAHREN ZUM HERSTELLEN DER LEITERPLATTE, DES STEUERGERÄTS UND DER EINRICHTUNG**
PRINTED CIRCUIT BOARD, CONTROL DEVICE, DEVICE WITH AN APPARATUS CONTROLLED BY THE CONTROL DEVICE AND MOTOR VEHICLE THEREWITH AND METHOD FOR PRODUCING THE PRINTED CIRCUIT BOARD, THE CONTROL DEVICE AND THE DEVICE
CARTE DE CIRCUIT IMPRIMÉ, APPAREIL DE COMMANDE, INSTALLATION COMPRENANT UN DISPOSITIF POUVANT ÊTRE COMMANDÉ PAR L'APPAREIL DE COMMANDE ET VÉHICULE AUTOMOBILE EN ÉTANT ÉQUIPÉ, ET PROCÉDÉ DE FABRICATION DE LA CARTE DE CIRCUIT IMPRIMÉ, DE L'APPAREIL DE COMMANDE ET DE L'INSTALLATION

(30) Priorität: 28.06.2012 DE 102012012914
(43) Veröffentlichungstag der Anmeldung: 06.05.2015
(73) Patentinhaber: ZF CV Systems Hannover GmbH, 30453 Hannover (DE)
(72) Erfinder: BODE, Jürgen, 31139 Hildesheim (DE); WÖHNER, Karl-Heinz, 30826 Garbsen (DE)
(86) Internationale Anmeldenummer: PCT/EP2013/001737
(87) Internationale Veröffentlichungsnummer: WO 2014/000862

(56) Entgegenhaltungen:
- EP-A1- 1 906 719
- EP-A2- 1 049 362
- DE-A1- 10 015 270
- US-A1- 2002 131 254
- US-A1- 2005 035 845
- US-A1- 2008 197 967
- Anonymous: "Durchkontaktierung - Wikipedia", , 5 February 2012 (2012-02-05), XP055710992, Retrieved from the Internet: URL:https://de.wikipedia.org/w/index.php?t itle=Durchkontaktierung&oldid=99290062 [retrieved on 2020-07-02]

## Beschreibung

Die Erfindung betrifft eine Leiterplatte auf Basis bekannter Microvia-Entwärmungstechnologie, wobei nämlich Entwärmungsmittel, welche diese Microvias aufweisen, zur Entwärmung einer Bauteilseite der Leiterplatte zu einer der Bauteilseite gegenüberliegenden Rückseite der Leiterplatte vorgesehen sind. Die Rückseite ist ferner derart ausgebildet, dass diese Rückseite zur Entwärmung der Leiterplatte, insbesondere an einer im Wesentlichen ebenen Kontaktfläche, thermisch leitend mit einer Wärmesenke kontaktierbar ist. Beispielsweise kann an der Rückseite ein Kühlkörper befestigt werden.

Weiter betrifft die Erfindung ein Steuergerät mit dieser Leiterplatte, welches insbesondere für ein Kraftfahrzeug vorgesehen ist. Ferner betrifft die Erfindung eine Einrichtung, welche zusätzlich zu dem Steuergerät eine von diesem Steuergerät steuerbare Vorrichtung aufweist, sowie ein Kraftfahrzeug mit dem Steuergerät oder mit der Einrichtung. Schließlich betrifft die Erfindung noch Verfahren zum Herstellen der Leiterplatte, zum Herstellen des Steuergeräts sowie zum Herstellen der Einrichtung.

Eine bekannte erste Leiterplatte auf Basis der Microvia-Entwärmungstechnologie nutzt einen an der Rückseite befestigten Kühlkörper als Wärmesenke und kann in Umgebungstemperaturen bis etwa 120 °C eingesetzt werden. Für einen Einsatz in einer Umgebung mit noch höheren Temperaturen ist diese erste bekannte Leiterplatte nicht geeignet.

Darüber hinaus ist eine zweite Leiterplatte mit Hybrid-Technologie bekannt, die auf Basis von Keramik-Substraten in Kombination mit dem Einsatz von ungehäusten integrierten Schaltkreisen basiert. Die ungehäusten integrierten Schaltkreise werden mittels Dünndraht-Bondtechnologie mit den Keramik-Substraten verbunden. Die Keramik-Substrate basieren entweder auf der sogenannten Dickschicht-Hybridtechnik oder sind sogenannte Niedertemperatur-Einbrand-Keramiken (LTCC = low temperature co-fired ceramics).

Diese zweite bekannte Leiterplatte ist zwar für den Einsatz im Bereich von Temperaturen oberhalb von 120 °C geeignet. Allerdings weisen in Dickschicht-Hybridtechnologie hergestellte Keramik-Substrate nur eine niedrige Integrationsdichte auf. Niedertemperatur-Einbrand-Keramiken sind hingegen nur unter hohen Kosten herzustellen. Darüber hinaus sind ungehäuste integrierte Schaltkreise oftmals nur schwer verfügbar. Ferner muss zur Herstellung die sogenannte Leitklebetechnik verwendet werden. Für das Verbinden der ungehäusten integrierten Schaltkreise mit den Keramik-Substraten mittels der Dünndraht-Bondtechnologie ist zudem ein Reinraum netwendig, was die Herstellung aufwendig und teuer macht.

Ferner ist eine dritte Leiterplatte bekannt, nämlich eine Standard FR 4-Leiterplatte mit konventionellen Durchkontaktierungen (PTH = plated-through holes). Diese dritte bekannte Leiterplatte weist ferner gedruckte Carbon-Polymer-Widerstände bzw. Widerstände in Carbon-Druck-Technologie, insbesondere an ihrer Bauteilseite, auf. Damit wird gegenüber dem Einsatz von gehäusten Standard-Widerständen eine höhere Integrationsdichte erreicht.

EP 1 049 362 A2 offenbart eine Leiterplatte mit einem wärmeleitenden Bereich, wobei zum Abführen der Wärme der an der Leiterplatte angebrachten Bauteile die Leiterplatte an mindestens einer Stelle mit einem Ankopplungsbereich zu versehen ist, der mit Hilfe eines thermisch leitenden Klebers an einem Träger angeklebt wird, der ebenfalls wärmen leitende Eigenschaften aufweist. Der Ankopplungsbereich kann bspw. durch ein Array von Microvias gebildet werden. Diese können mindestens teilweise mit dem thermisch leitenden Kleber gefüllt werden.

Der Erfindung liegt die Aufgabe zugrunde, eine Steuerung einer Vorrichtung an einem Kraftfahrzeug bereitzustellen, wobei eine Leiterplatte eines hierfür verwendeten Steuergeräts sowie das Steuergerät für den Einsatz in einer Umgebungstemperatur oberhalb von 125 °C geeignet und unempfindlich gegenüber mechanischem Stress sowie die Leiterplatte kostengünstiger als eine Leiterplatte auf Basis von Keramik-Substraten sein soll.

Die Erfindung löst diese Aufgabe mit einer Leiterplatte nach Anspruch 1, mit einem Steuergerät nach Anspruch 4, mit einer Einrichtung nach Anspruch 7, mit einem Kraftfahrzeug nach Anspruch 8, mit einem Verfahren zum Herstellen einer Leiterplatte nach Anspruch 9, mit einem Verfahren zum Herstellen eines Steuergeräts nach Anspruch 12 und mit einem Verfahren zum Herstellen einer Einrichtung nach Anspruch 15.

Die Erfindung druckt bei einer Leiterplatte auf Basis der Microvia-Entwärmungstechnologie zusätzlich Carbon-Polymer-Widerstände an der Rückseite, insbesondere auf eine rückseitige Isolator-Außenlage der herzustellenden Leiterplatte. Die Carbon-Polymer-Widerstände sind hiernach in einer bauteilseitigen Leiter-Außenlage bzw. in einer rückseitigen Leiter-Außenlage bzw. in der Leiter-Innenlage der Leiterplatte angeordnet. Die Leiter-Außenlagen und die Leiterinnenlage werden vorzugsweise vor dem Drucken des Carbon-Polymer-Widerstands in der jeweiligen Lage strukturiert.

Die Erfindung hat erkannt, dass durch die Kombination der Microvia-Entwärmungstechnologie mit gedruckten Carbon-Polymer-Widerständen nicht nur ein höherer Integrationsgrad erreicht wird, sondern die Leiterplatte auch in einer Umgebung mit höheren Temperaturen eingesetzt werden kann, als jede Leiterplatte mit nur einer dieser Technologien für sich. Insbesondere kann die Erfindung in einer Umgebung mit einer Umgebungstemperatur von mehr als 125 °C eingesetzt werden. Darüber hinaus können gehäuste elektronische Bauelemente unter Einsatz bekannter Löttechnologie auf der Leiterplatte angebracht werden. Ungehäuste Bauelemente sowie die Dünndraht-Bondtechnologie brauchen nicht zum Einsatz kommen, so dass auf einen Reinraum bei der Fertigung verzichtet werden kann.

Die Erfindung stellt einen kostengünstigen Ersatz für Leiterplatten auf Basis von Niedertemperatur-Einbrand-Keramiken bereit und ermöglicht gegenüber der Dickschicht-Hybrid-Technik eine vergleichsweise höhere Integrationsdichte.

Die erfindungsgemäße Leiterplatte ist dabei eine kompakt gestaltete Leiterplatte bzw. eine sogenannte High-Density-Interconnect (HDI)-Leiterplatte mit Entwärmungsmitteln. Die Entwärmungsmittel umfassen Microvias und Burried Vias, welche gemeinsam eine Entwärmung von der Bauteilseite zur Rückseite bzw. von der an der Bauteilseite angeordneten bauteilseitigen Leiter-Außenlage zu der an der Rückseite angeordneten rückseitigen Leiter-Außenlage ermöglichen.

Die Microvias sind metallisch beschichtete oder gefüllte Laserbohrungen, welche die Bauteilseite bzw. Rückseite mit jeweils einer Leiter-Innenlage der Leiterplatte thermisch leitend verbinden und somit als sogenannte Blind Vias ausgebildet sind. Zwei Leiter-Innenlagen sind durch die in einer Isolator-Innenlage angeordneten Burried Vias thermisch leitend miteinander verbunden. Die Burried Vias sind, insbesondere metallische, Innen-Durchkontaktierungen bzw. Kern-Durchkontaktierungen. Die Leiter-Innenlagen sind elektrisch bzw. thermisch leitend und weisen vorzugsweise Kupfer auf und sind daher Kupferinnenlagen. Darüber hinaus kann die Leiterplatte zusätzlich Durchkontaktierungen bzw. sogenannte Thermovias zwischen der Bauteilseite und der Rückseite aufweisen. Der minimale Durchmesser der Microvias beträgt weniger als 150 µm. Die Burried Vias bzw. die Thermovias weisen jeweils einen minimalen Durchmesser von mehr als 150 µm auf.

Die Carbon-Polymer-Widerstände werden mittels eines Carbonlacks bzw. Carbonleitlacks gebildet, welcher ein schwarzer Lack auf Epoxyd-Basis ist, der leitendes Kohlenstoffpulver oder Graphitpulver als Füllstoff enthält. Dieser Carbonlack überbrückt eine Lücke zwischen zwei Kontaktstellen, die einen vergleichsweise hohen elektrischen Leitwert aufweisen, wobei sich der elektrische Widerstand aus der Konzentration der leitenden Substanzen im Carbonlack sowie aus der Geometrie des aufgebrachten Carbonlacks ergibt. Bei der Fertigung wird der Carbonlack vorzugsweise in Bereichen der Bauteilseite, bzw. Rückseite bzw. in einer Leiter-Innenlage aufgetragen, die von einem Lötstopplack ausgespart sind.

Vorteilhafterweise werden die Carbon-Polymer-Widerstände, insbesondere ausschließlich, an der Rückseite bzw. auf die rückseitige Isolator-Außenlage gedruckt. Insbesondere werden die Carbon-Polymer-Widerstände an der zur Wärmesenke weisenden Seite der Leiterplatte vorgesehen. Dadurch ist eine effektive Entwärmung der Carbon-Polymer-Widerstände zur Wärmesenke erreichbar. Eine besonders vorteilhafte Entwärmung wird erreicht, wenn die Carbon-Polymer-Widerstände an der Rückseite angeordnet sind. Die Erfindung hat erkannt, dass die Oberfläche der Rückseite nur unwesentliche Erhebungen aufgrund des Carbonlacks bzw. aufgrund der Carbon-Polymer-Widerstände aufweist und daher als im Wesentlichen eben anzusehen ist, so dass die Rückseite, insbesondere an einer im Wesentlichen ebenen Kontaktfläche, mit der Wärmesenke bzw. mit einem Kühlkörper kontaktierbar ist. Die Anordnung der Carbon-Polymer-Widerstände an der Rückseite spart zudem Platz an bzw. auf der Bauteilseite der Leiterplatte, der somit vollständig für die Anordnung gehäuster elektronischer Bauelemente zur Verfügung steht.

Gemäß einer vorteilhaften Ausführungsform sind die an der Rückseite angeordneten Carbon-Polymer-Widerstände zusätzlich mit Lötstopplack abgedeckt. Der Lötstopplack isoliert die Carbon-Polymer-Widerstände elektrisch gegen die kontaktierbare Wärmesenke, die vorzugsweise ein Metall aufweist bzw. aus Metall besteht, und lässt die Carbon-Polymer-Widerstände zugleich thermisch leitend mit der Wärmesenke verbunden.

Gemäß einer vorteilhaften Ausführungsform weist die Leiterplatte gehäuste elektronische Bauelemente auf der Bauteilseite auf. Die gehäusten elektronischen Bauelemente können mittels üblicher Löttechnologie an der Leiterplatte befestigt werden. Ein Reinraum und der Einsatz von ungehäusten Bauelementen sowie von Dünndraht-Bondtechnologie ist hierfür nicht erforderlich, so dass die Leiterplatte kostengünstig mit elektronischen Bauelementen, insbesondere auch integrierten Schaltkreisen, bestückt werden kann. Ferner wird die Wärme von diesen elektronischen Bauelementen vorteilhaft mittels der Entwärmungsmittel bzw. mittels der Microvias und der Burried Vias zur Rückseite und somit zur Wärmesenke abgeführt.

Zum Herstellen eines Steuergeräts mit der erfindungsgemäßen Leiterplatte wird die Rückseite dieser Leiterplatte zur Entwärmung der Leiterplatte thermisch leitend mit einem Kühlkörper kontaktiert. Die Wärmesenke weist dabei diesen Kühlkörper auf bzw. ist der Kühlkörper. Ein somit hergestelltes erfindungsgemäßes Steuergerät, welches insbesondere für ein Kraftfahrzeug vorgesehen ist, ist somit wie die Leiterplatte für den Einsatz bei einer Betriebstemperatur von mehr als 125 °C geeignet und kann kostengünstig hergestellt werden. Insbesondere kann das Steuergerät direkt in oder an einer Vorrichtung des Kraftfahrzeugs angeordnet werden, die eine hohe Betriebstemperatur von mehr als 125 °C erreicht, wie beispielsweise ein Getriebe des Fahrzeugs.

Vorteilhafter Weise weist das Steuergerät ein Gehäuse auf, in welchem die Leiterplatte angeordnet ist und das den Kühlkörper aufweist. Das Gehäuse bzw. ein Teil des Gehäuses nimmt somit die Funktion der Wärmesenke bzw. des Kühlkörpers ein. Ein separater Kühlkörper ist nicht notwendig.

Gemäß einer vorteilhaften Weiterbildung des Steuergeräts ist die Leiterplatte thermisch leitend und elektrisch isolierend mit dem Kühlkörper verklebt, insbesondere mittels eines sogenannten Transferklebers. Mittels des Klebers kann kostengünstig die thermisch leitende Verbindung hergestellt werden, wobei evtl. Abweichungen von einer absolut planen Oberfläche der Rückseite mittels des Klebers vorteilhaft überbrückt werden.

Gemäß einer alternativen Ausführungsfom ist die Leiterplatte mittels einer elektrisch isolierenden Klebefolie mit dem Kühlkörper verklebt. Der Einsatz der Klebefolie verhindert direkte Kontakte der Rückseite bzw. der Carbon-Polymer-Widerstände an der Rückseite mit dem Kühlkörper, so dass in jedem Fall eine elektrische Isolation der Rückseite zum Kühlkörper gegeben ist und daher auf die Abdeckung der Carbon-Polymer-Widerstände mit Lötstopplack verzichtet werden kann.

Die erfindungsgemäße Einrichtung ist insbesondere für ein Kraftfahrzeug vorgesehen und weist zusätzlich zum erfindungsgemäßen Steuergerät eine elektrisch vom Steuergerät steuerbare Vorrichtung, wie beispielsweise das o.g. Getriebe auf. Diese Vorrichtung weist ein Vorrichtungsgehäuse auf, mit dem die Rückseite zur Entwärmung der Leiterplatte thermisch leitend kontaktiert ist. Insbesondere ist der Kühlkörper somit Teil des Vorrichtungsgehäuses. Es kann somit vorteilhaft eine Entwärmung der Leiterplatte zum Vorrichtungsgehäuse stattfinden, wobei das Vorrichtungsgehäuse seinerseits gekühlt sein kann. Insbesondere ist das Gehäuse des Getriebes mittels eines Getriebeöls gekühlt, welches in der Regel maximal eine Temperatur von 130 °C erreicht. Die Einrichtung mit der Vorrichtung und mit dem Steuergerät kann zudem vorteilhaft als Einheit vertrieben, gelagert und eingebaut werden, was wiederum Kosten spart.

Das erfindungsgemäße Fahrzeug weist das erfindungsgemäße Steuergerät oder die erfindungsgemäße Einrichtung auf.

Gemäß einer besonderen Ausführungsform der Erfindung ist zusätzlich zur erfindungsgemäßen Leiterplatte wenigstens eine weitere erfindungsgemäß oder anders ausgebildete Leiterplatte mit der selben Wärmesenke, insbesondere mit dem selben Kühlkörper, thermisch leitend kontaktiert, insbesondere verklebt.

Weitere vorteilhafte Ausführungsformen ergeben sich aus den Ansprüchen sowie aus dem anhand der Zeichnung näher erläuterten Ausführungsbeispiel. In der Zeichnung zeigen:
- Fig. 1: eine bestückte Leiterplatte, deren Rückseite mit einem Kühlkörper kontaktiert ist, gemäß einem Ausführungsbeispiel der Erfindung in einer Seitenansicht in vereinfachter schematischer Darstellung;
- Fig. 2: einen Ausschnitt der Unterseite der Leiterplatte von Fig. 1 in einer Draufsicht in vereinfachter schematischer Darstellung;
- Fig. 3: ein Steuergerät mit der hinter einem Deckel angeordneten Leiterplatte des Ausführungsbeispiels gemäß den Fig. 1 und 2 sowie mit einem metallischen Außenteil, auf dem die Leiterplatte angeordnet ist und einem Rahmen gemäß einem Ausführungsbeispiel der Erfindung in einer Draufsicht in vereinfachter schematischer Darstellung;
- Fig. 4: das metallische Außenteil des Steuergeräts des Ausführungsbeispiels gemäß Fig. 3 in einer Draufsicht und
- Fig. 5: den Rahmen des Steuergeräts des Ausführungsbeispiels gemäß Fig. 3 in einer Draufsicht.

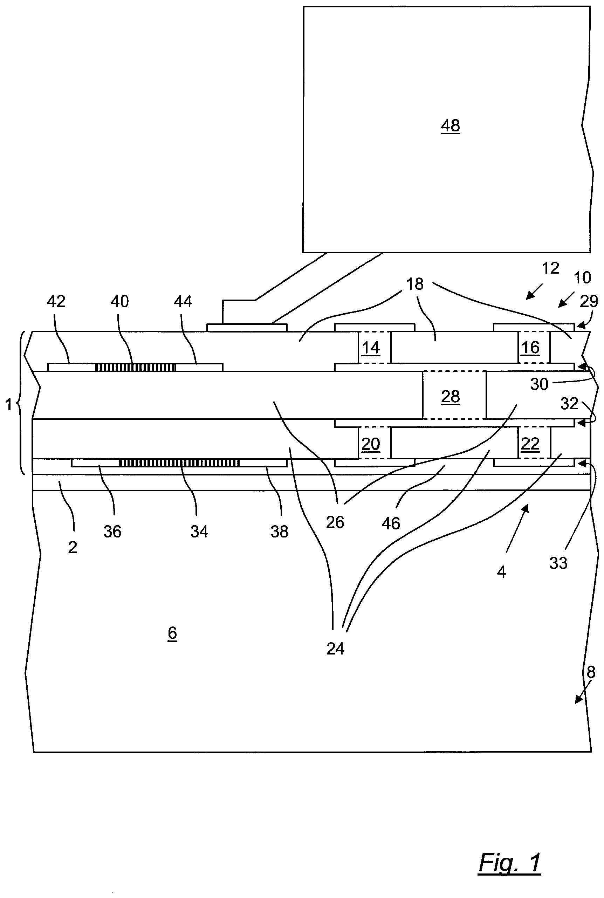

Fig. 1 zeigt einen Ausschnitt einer Leiterplatte 1 in einer Seitenschnittdarstellung. Die Leiterplatte 1 ist mittels einer Klebstoffschicht 2 an ihrer Rückseite 4 mit einem Kühlkörper 6 thermisch leitend kontaktiert, der eine Wärmesenke bzw. Teil einer Wärmesenke 8 ist. Die Leiterplatte 1 kann daher zusammen mit elektronischen Bauteilen, mit denen die Leiterplatte 1 bestückt ist, über ihre Rückseite 4 zum Kühlkörper 6 bzw. zur Wärmesenke 8 entwärmt und somit gekühlt werden. Zur Kühlung bzw. Entwärmung einer Bauteilseite 10 der Leiterplatte 1 zur Rückseite 4 weist die Leiterplatte 1 Entwärmungsmittel 12 auf. Die Entwärmungsmittel 12 umfassen Microvias 14 und 16 in einer bauteilseitigen Dielektrikum-Außenlage bzw. Isolator-Außenlage 18 der Leiterplatte 1 sowie weitere Microvias 20 und 22 in einer rückseitigen Dielektrikum-Außenlage bzw. Isolator-Außenlage 24 der Leiterplatte 1. Die Dielektrika bzw. Isolator-Außenlagen 18 und 24 sind ein sogenanntes Prepreg.

Zwischen den Isolator-Außenlagen 18 und 24 ist eine Dielektrikum-Innenlage bzw. Isolator-Innenlage 26 der Leiterplatte 1 angeordnet, die ein Kernmaterial aufweist bzw. aus einem Kernmaterial besteht und somit ein Dielektrikum-Kern ist. Die Entwärmungsmittel 12 umfassen ferner ein im Kern bzw. in der Isolator-Innenlage 26 angeordnetes sogenanntes Burried Via, welches gegenüber den Microvias einen größeren Durchmesser aufweist. Insbesondere kann das Burried Via 28 während der Fertigung der Leiterplatte 1 auf herkömmlich Weise durch mechanisches Bohren eines Lochs durch die Isolator-Innenlage 26 und metallisches Beschichten oder Füllen dieses Lochs hergestellt werden, wohingegen die Microvias 14, 16, 20 und 22 metallisch beschichtete oder gefüllte Laserbohrungen sind, welche als Sacklöcher in die Leiterplatte 1 vor ihrer Fertigstellung bzw. in die Isolator-Außenlagen 18 und 24 eingebracht werden.

Während die Microvias 14, 16, 20 und 22 sowie das Burried Via 28 für eine vertikale Entwärmung sorgen, die ggf. durch von der Bauteilseite 10 zur Rückseite 4 reichende, sogenannte Thermovias unterstützt werden kann, findet eine horizontale Entwärmung bzw. Wärmespreizung in einer bauteilseitigen Leiter-Außenlage 29, in einer ersten Leiter-Innenlage 30, in einer zweiten Leiter-Innanlage 32 und in einer rückseitigen Leiter-Außenlage 33 statt. Die Leiter-Außenlagen 29 und 33 sind vorzugsweise Kupfer-Außenlagen. Die Leiter-Innenlagen 30 und 32 sind vorzugsweise Kupferinnenlagen. Teile der Leiter-Innenlagen verbinden die Microvias 14, 16, 20 und 22 thermisch leitend mit dem Burried Via 28. Die Kupferinnenlagen bzw. Leiter-Innenlagen 30 und 32 werden bei der Fertigung vor Aufbringen der Dielektrika bzw. Isolator-Außenlagen 18 und 24 auf dem Kern bzw. der Isolator-Innenlage 26 strukturiert.

In der rückseitigen Leiter-Außenlage 33 bzw. auf der rückseitigen Isolator-Außenlage 24 ist ein erster Carbon-Polymer-Widerstand 34 zwischen einer ersten Kontaktstelle 36 und einer zweiten Kontaktstelle 38 gedruckt. Ein zweiter Carbon-Polymer-Widerstand 40 ist in der ersten Leiter-Innenlage 30 bzw. auf der Isolator-Innenlage 26 zwischen einer dritten Kontaktstelle 42 und einer vierten Kontaktstelle 44 gedruckt. Die Carbon-Polymer-Widerstände 34 und 40 werden dadurch hergestellt, dass ein Carbon-Polymer-Lack bei der Herstellung der Leiterplatte, insbesondere nach Strukturierung der Leiter-Innenlage 30, auf die Isolator-Innenlage 26 und, insbesondere nach Strukturierung der rückseitigen Leiter-Außenlage, auf die rückseitige Isolator-Außenlage 24 aufgebracht wird. Die Carbon-Polymer-Widerstände 34 und 40 sind hiernach in der rückseitigen Leiter-Außenlage 33 bzw. in der ersten Leiter-Innenlage 30 angeordnet. Zur Herstellung des gewünschten Widerstandswerts wird in der Regel zunächst mehr Carbon-Polymer-Lack als nötig gedruckt und anschließend teilweise wieder entfernt bzw. durch gezielte Schnitte, bspw. mittels eines Lasers, modifiziert, bis der gewünschte Widerstandswert mit einer Genauigkeit von ± 5 % erreicht wird.

Der erste Carbon-Polymer-Widerstand 34 ist thermisch günstig an der Rückseite 4 angeordnet, so dass der erste Carbon-Polymer-Widerstand 34 effektiv zum Kühlkörper 6 entwärmt werden kann. Da der Kühlkörper 6 vorteilhafterweise ein Metall aufweist bzw. aus Metall besteht, ist der erste Carbon-Polymer-Widerstand 34 einschließlich der Kontaktstellen 36 und 38 zur elektrischen Isolation mit einer Schicht Lötstopplack 46 abgedeckt. Der Lötstopplack 46 deckt verbreiterte Endstellen der Microvias 20 und 22 sowie den ersten Carbon-Polymer-Widerstand 34 mit seinen Kontaktstellen 36 und 38 nebst weiteren nicht dargestellten Carbon-Polymer-Widerständen mit ihren Kontaktstellen bzw. die rückseitige Leiter-Außenlage 33 ab.

Eine Entwärmung bzw. Kühlung des in der ersten Leiter-Innenlage 30 angeordneten bzw. auf die Isolator-Innenlage 26 applizierten zweiten Carbon-Polymer-Widerstands 40 erfolgt über die Entwärmungsmittel 12 zur Rückseite 4 und zum Kühlkörper 6. Auf der Bauteilseite 10 ist ein gehäustes elektronisches Bauelement 48 nebst weiteren nicht dargestellten gehäusten Bauelementen angeordnet. Das gehäuste elektronische Bauelement 48 wird über die Entwärmungsmittel 12 zum Kühlkörper 6 entwärmt bzw. gekühlt.

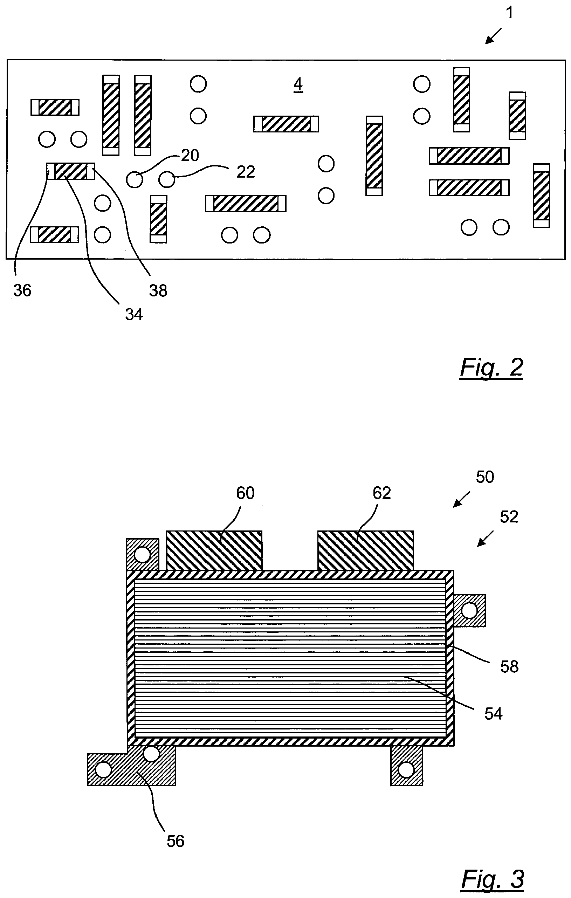

Fig. 2 zeigt einen Ausschnitt der Rückseite 4 der Leiterplatte 1 des Ausführungsbeispiels gemäß Fig.1. Gleiche Bezugszeichen bezeichnen hier wie in allen weiteren Figuren gleiche Bauteile. Der erste Carbon-Polymer-Widerstand 34 ist zusammen mit seinen Kontaktstellen 36 und 38 durch den Lötstopplack 46 sichtbar. Daneben sind die verbreiterten Endstellen der Microvias 20 und 22 angeordnet. An der Rückseite 4 sind zahlreiche weitere Carbon-Polymer-Widerstände angeordnet und zahlreiche weitere verbreiterte Endstellen von Microvias sichtbar, die hier nicht weiter bezeichnet sind. Zumindest nach Aufbringen des Lötstopplacks 46 weist die Rückseite 4 eine im Wesentlichen ebene Oberfläche auf. Zumindest nach Auftragen des Klebers bzw. der Klebstoffschicht 2 kann eine durchgehende bzw. flächige thermische Kontaktierung zur ebenen bzw. glatten Oberfläche des Kühlkörpers 6 hergestellt werden.

Fig. 3 zeigt ein Steuergerät 50 zum Steuern einer Vorrichtung, bspw. eines Getriebes, an einem Kraftfahrzeug. Das Steuergerät 50 weist ein Gehäuse 52 auf. Im Inneren des Gehäuses 52 ist, in der Fig. 3 verdeckt hinter einem Deckel 54 des Gehäuses 52, die Leiterplatte 1 angeordnet. Insbesondere ist die Leiterplatte 1 mit einem metallischen Außenteil 56 bzw. Gehäuseunterteil mittels der Klebstoffschicht 2 verklebt. Ein Rahmen 58 des Gehäuses 52 ist ebenfalls mit dem metallischen Außenteil 56 verbunden und trägt den Deckel 54. Ferner sind am Rahmen 58 eine erste Steckkupplung 60 und eine zweite Steckkupplung 62 des Steuergeräts 50 angeordnet, die zur Verbindung mit Außensteckern vorgesehen sind.

Das Steuergerät 50 kann mittels des metallischen Außenteils 56 zur Entwärmung an die genannte Vorrichtung, insbesondere ein Gehäuse des genannten Getriebes, geschraubt sein. Das Steuergerät 50 steuert diese Vorrichtung und bildet zusammen mit dieser Vorrichtung eine Einrichtung des Fahrzeugs. Alternativ zu dem gezeigten Ausführungsbeispiel kann das metallische Außenteil 56 auch entfallen bzw. direkt durch ein Gehäuse bzw. Gehäuseteil einer Vorrichtung des Fahrzeugs ersetzt sein, so dass die Leiterplatte 1 direkt mit dem Gehäuse bzw. Gehäuseteil der Vorrichtung verklebt ist.

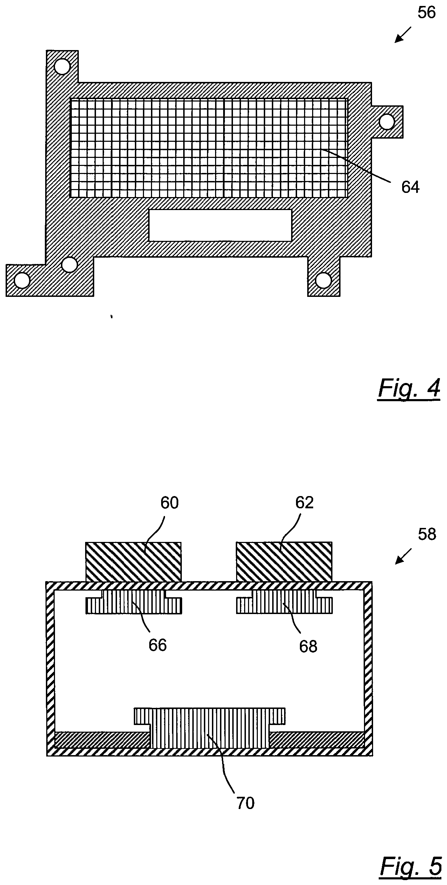

Fig. 4 zeigt das metallische Außenteil 56 des Steuergeräts 50 des Ausführungsbeispiels gemäß Fig. 3 in vereinfachter schematischer Darstellung in einer Draufsicht. Insbesondere ist die zum Inneren des Steuergeräts 50 weisende Seite des metallischen Außenteils 56 dargestellt. Auf dieser Seite ist eine ebene Fläche 64 vorgesehen, die zur Aufnahme der Leiterplatte 1 durch Verkleben bzw. zur Kontaktierung mit der Leiterplatte 1 über deren Rückseite 4 vorgesehen ist.

Fig. 5 zeigt den Rahmen 58 des Steuergeräts 50 des Ausführungsbeispiels gemäß Fig. 3 einschließlich der Steckkupplungen 60 und 62. Im Rahmen 58 ist eine erste Kontaktierung 66 und eine zweite Kontaktierung 68 zum Herstellen elektrischer Verbindungen, insbesondere Datenverbindungen oder Signalverbindungen, der an die Steckkupplungen 60 und 62 anschließbaren Außenstecker mit der Leiterplatte 1 vorgesehen. Ferner weist der Rahmen 58 eine dritte Kontaktierung 70 zum Herstellen weiterer elektrischer Verbindungen zur Leiterplatte 1 auf. Die Kontaktierungen 66, 68 und 70 sind dabei zur Kontaktierung der Leiterplatte 1 an ihrer Bauteilseite 10 vorgesehen. Die Bauteilseite 10 weist hierfür entsprechende Kontaktstellen auf.

Zur Herstellung des Steuergeräts 50 wird zunächst die Leiterplatte 1 einschließlich an ihrer Bauteilseite 10 angeordneter gehäuster elektronischer Bauelemente 48 hergestellt, nachfolgend die Leiterplatte 1 auf das metallische Außenteil 65 geklebt und nachfolgend der Rahmen 58 auf das metallische Außenteil 65 gesetzt, wobei Kontakte der Kontaktierungen 66, 68 und 70 jeweils mit der Leiterplatte 1 hergestellt werden. Schließlich wird zum Schutz der Leiterplatte 1 nebst Kontaktierungen 66, 68, 70 der Deckel 54 auf den Rahmen 58 gesetzt.

Die Erfindung ermöglicht auf kostengünstige Weise das Herstellen eines Steuergeräts 50 mit Leiterplatte 1, welches bei Temperaturen von mehr als 125 °C, insbesondere zur Steuerung einer Einrichtung eines Kraftfahrzeugs, eingesetzt werden kann.

Alle in der vorstehenden Beschreibung und in den Ansprüchen genannten Merkmale sind sowohl einzeln als auch in beliebiger Kombination miteinander einsetzbar. Die Offenbarung der Erfindung ist somit nicht auf die beschriebenen bzw. beanspruchten Merkmalskombinationen beschränkt. Vielmehr sind alle Merkmalskombinationen als offenbart zu betrachten.

## Patentansprüche

1. Leiterplatte (1) mit einer Bauteilseite (10), mit einer der Bauteilseite (10) gegenüber liegenden Rückseite (4), deren Oberfläche derart im Wesentlichen eben ausgebildet ist, dass die Rückseite (4) zur Entwärmung der Leiterplatte (1), insbesondere an einer im Wesentlichen ebenen Kontaktfläche, thermisch leitend mit einer Wärmesenke (8) kontaktiert ist, und mit Microvias (14, 16, 20, 22) sowie Burried Vias (28) aufweisenden Entwärmungsmitteln (12) zur Entwärmung der Bauteilseite (10) zur Rückseite (4), wobei mehrere der Microvias (14, 16) die Bauteilseite (10) mit einer Leiter-Innenlage (30) der Leiterplatte (1) thermisch leitend verbinden und weitere der Microvias (20, 22) die Rückseite (4) mit einer weiteren Leiter-Innenlage (32) der Leiterplatte (1) thermisch leitend verbinden und zwei Leiter-Innenlagen (30, 32) durch die in einer Isolator-Innenlage (26) angeordneten Burried Vias (28) thermisch leitend miteinander verbunden sind,
**gekennzeichnet durch**,
gedruckte Carbon-Polymer-Widerstände (34, 40) an der Rückseite (4) der Leiterplatte (1).

2. Leiterplatte nach Anspruch 1,
**dadurch gekennzeichnet, dass**
die an der Rückseite (4) gedruckten Carbon-Polymer-Widerstände (34, 40) mit Lötstopplack (46) abgedeckt sind.

3. Leiterplatte nach Anspruch 1 oder 2 ,
**gekennzeichnet durch**
gehäuste elektronische Bauelemente (48) auf der Bauteilseite (10).

4. Steuergerät, insbesondere für ein Kraftfahrzeug, mit einer Leiterplatte (1) nach einem der vorherigen Ansprüche und mit einem Kühlkörper (6), mit dem die Rückseite (4) zur Entwärmung der Leiterplatte (1) thermisch leitend kontaktiert ist, wobei die Wärmesenke (8) diesen Kühlkörper (6) aufweist.

5. Steuergerät nach Anspruch 4
**gekennzeichnet durch**
ein Gehäuse (52), in dem die Leiterplatte (1) angeordnet ist und das den Kühlkörper (6) aufweist.

6. Steuergerät nach Anspruch 4 oder 5,
**dadurch gekennzeichnet, dass**
die Leiterplatte (1) thermisch leitend und elektrisch isolierend mit dem Kühlkörper (6) verklebt ist.

7. Einrichtung, insbesondere für ein Kraftfahrzeug, mit einem Steuergerät (50) nach einem der Ansprüche 4 bis 6 und mit einer vom Steuergerät (50) elektrisch steuerbaren Vorrichtung, die ein Vorrichtungsgehäuse aufweist, mit dem die Rückseite (4) zur Entwärmung der Leiterplatte (1) thermisch leitend kontaktiert ist.

8. Kraftfahrzeug mit einem Steuergerät (50) nach einem der Ansprüche 4 bis 6 oder mit einer Einrichtung nach Anspruch 7.

9. Verfahren zum Herstellen einer Leiterplatte (1), die eine Bauteilseite (10) und eine der Bauteilseite (10) gegenüberliegende Rückseite (4) aufweist, deren Oberfläche derart im Wesentlichen eben ausgebildet ist, dass die Rückseite (4) zur Entwärmung der Leiterplatte (1), insbesondere an einer im Wesentlichen ebenen Kontaktfläche, thermisch leitend mit einer Wärmesenke (8) kontaktiert ist, wobei Entwärmungsmittel (12) zur Entwärmung der Bauteilseite (10) zur Rückseite (4), die Microvias (14, 16, 20, 22) sowie Burried Vias (28) aufweisen, in der herzustellenden Leiterplatte (1) vorgesehen werden, wobei mehrere der Microvias (14, 16) die Bauteilseite (10) mit einer Leiter-Innenlage (30) der Leiterplatte (1) thermisch leitend verbinden und weitere der Microvias (20, 22) die Rückseite (4) mit einer weiteren Leiter-Innenlage (32) der Leiterplatte (1) thermisch leitend verbinden und zwei Leiter-Innenlagen (30, 32) durch die in einer Isolator-Innenlage (26) angeordneten Burried Vias (28) thermisch leitend miteinander verbunden sind,**dadurch gekennzeichnet, dass**
an der Rückseite (4) der herzustellenden Leiterplatte (1) Carbon-Polymer-Widerstände (34, 40) gedruckt werden.

10. Verfahren nach Anspruch 9,
**dadurch gekennzeichnet, dass**
die Carbon-Polymer-Widerstände (34, 40) mit Lötstopplack (46) abgedeckt werden.

11. Verfahren nach Anspruch 9 oder 10,
**dadurch gekennzeichnet, dass**
auf der Bauteilseite (10) gehäuste elektronische Bauelemente (48) angeordnet werden.

12. Verfahren zum Herstellen eines Steuergeräts (50), insbesondere für ein Kraftfahrzeug, wobei eine Leiterplatte (1) mittels eines Verfahrens nach einem der Ansprüche 9 bis 11 hergestellt wird und die Rückseite (4) derart thermisch leitend mit einem Kühlkörper (6), den die Wärmesenke (8) aufweist, kontaktiert wird, dass die Leiterplatte (1) über die Rückseite (4) zur Wärmesenke (8) entwärmt werden kann.

13. Verfahren nach Anspruch 12,
**dadurch gekennzeichnet, dass**
die Leiterplatte (1) in einem Gehäuse (52) angeordnet wird, das den Kühlkörper (6) aufweist.

14. Verfahren nach Anspruch 12 oder 13,
**dadurch gekennzeichnet, dass**
die Leiterplatte (1) thermisch leitend und elektrisch isolierend mit dem Kühlkörper (6) verklebt wird.

15. Verfahren zum Herstellen einer Einrichtung, insbesondere für ein Kraftfahrzeug, wobei ein Steuergerät (50) dieser Einrichtung mittels eines Verfahrens nach einem der Ansprüche 12 bis 14 hergestellt wird und die Rückseite (4) zur Entwärmung der Leiterplatte (1) thermisch leitend mit einem Vorrichtungsgehäuse einer vom Steuergerät (50) elektrisch steuerbaren Vorrichtung der Einrichtung kontaktiert wird.

## Claims

1. A printed circuit board (1), with a component side (10), having a rear side (4) lying opposite the component side (10), the surface of which rear side being designed substantially flat such that the rear side (4) can be thermally conductively contacted with a heat sink (8), in particular on a substantially flat contact face, in order to cool the printed circuit board (1), and having cooling means (12), which comprise microvias (14, 16, 20, 22) and buried vias (28), for cooling the component side (10) in the direction of the rear side (4), wherein a plurality of the microvias (14, 16) connect the component side (10) to an inner conductor layer (30) of the printed circuit board (1) in a thermally conducting manner and further of the microvias (20, 22) connect the rear side (4) to a further inner conductor layer (32) of the printed circuit board (1) and two inner conductor layers (30, 32) are connected to each other in a thermally conducting manner by means of the buried vias (28) arranged in an inner insulator layer (26),
**characterized by**
printed carbon polymer resistors (34, 40) on the rear side (4) of the printed circuit board (1).

2. The printed circuit board according to claim 1,
**characterized in that**
the printed carbon polymer resistors (34, 40) on the rear side (4) are covered with solder resist (46).

3. The printed circuit board according to claim 1 or 2, **characterized by**
housed electronic components (48) on the component side (10).

4. A control device, in particular for a motor vehicle with a printed circuit board (1) according to any of the preceding claims and having a cooling body (6), with which the rear side (4) is thermally conductively contacted in order to cool the printed circuit board (1), wherein the heat sink (8) has this cooling body (6).

5. The control device according to claim 4, **characterized by**
a housing (52) in which the printed circuit board (1) is arranged and that has the cooling body (6).

6. The control device according to claim 4 or 5, **characterized in that**
the printed circuit board (1) is glued to the cooling body (6) in a thermally conducting and electrically insulating manner.

7. A device, in particular for a motor vehicle, with a control device (50) according to any of claims 4 to 6 and having an apparatus electrically controlled by the control device (50), which has an apparatus housing, to which the rear side (4) is thermally conductively contacted in order to cool the printing circuit board (1).

8. A motor vehicle with a control device (50) according to any of claims 4 to 6 or with a device according to claim 7.

9. A method for manufacturing a printed circuit board (1) having a component side (10) and a rear side (4) lying opposite the component side (10), the surface of which rear side being designed substantially flat such that the rear side (4) can be thermally conductively contacted with a heat sink (8), in particular on a substantially flat contact face, in order to cool the printed circuit board (1), wherein cooling means (12) for cooling the component side (10) to the rear side (4) having microvias (14, 16, 20, 22) and buried vias (28) are provided in the printed circuit board (1) to be manufactured, wherein a plurality of the microvias (14, 16) connect the component side (10) to an inner conductor layer (30) of the printed circuit board (1) in a thermally conducting manner and further of the microvias (20, 22) connect the rear side (4) to a further inner conductor layer (32) of the printed circuit board (1) and two inner conductor layers (30, 32) are connected to each other in a thermally conducting manner by means of the buried vias (28) arranged in an inner insulator layer (26), **characterized in that**
carbon polymer resistors (34, 40) are printed on the rear side (4) of the printed circuit board (1) to be manufactured.

10. The method according to claim 9, **characterized in that** the carbon polymer resistors (34, 40) are covered with solder resist (46).

11. The method according to claim 9 or 10, **characterized in that**
housed electronic components (48) are arranged on the component side (10).

12. A method for manufacturing a control device (50), in particular for a motor vehicle, wherein a printed circuit board (1) is manufactured by means of a method according to any of claims 9 to 11 and the rear side (4) is thermally conductively contacted with a cooling body (6), which has the heat sink (8), such that the printed circuit board (1) can be cooled via the rear side (4) to the heat sink (8).

13. The method according to claim 12, **characterized in that**
the printed circuit board (1) is arranged in a housing (52) that has the cooling body (6).

14. The method according to claim 12 or 13, **characterized in that**
the printed circuit board (1) is glued to the cooling body (6) in a thermally conducting and electrically insulating manner.

15. A method for manufacturing a device, in particular for a motor vehicle, wherein a control device (50) of this device is manufactured by means of a method according to any of claims 12 to 14 and the rear side (4) is thermally conductively contacted with an apparatus housing of an apparatus of the device that can be electrically controlled by the control device (50) in order to cool the printed circuit board (1).

## Revendications

1. Carte de circuit imprimé (1) comportant un côté composant (10), un côté dos (4) opposé au côté composant (10) et dont la surface est conçue de manière sensiblement plane de telle sorte que le côté dos (4) est en contact de manière thermoconductrice avec un puits de chaleur (8) pour refroidir la carte de circuit imprimé (1), en particulier sur une surface de contact sensiblement plane, et comportant des microvias (14, 16, 20, 22) et des moyens de refroidissement (12) présentant des vias enterrés (28) pour le refroidissement du côté composant (10) vers le côté dos (4), dans laquelle plusieurs des microvias (14, 16) relient de manière thermoconductrice le côté composant (10) à une couche interne conductrice (30) de la carte de circuit imprimé (1) et d'autres microvias (20, 22) relient de manière thermoconductrice le côté dos (4) à une autre couche interne conductrice (32) de la carte de circuit imprimé (1) et deux couches internes conductrices (30, 32) sont reliées l'une à l'autre de manière thermoconductrice par l'intermédiaire des vias enterrés (28) disposés dans une couche interne isolante (26), **caractérisé par**
des résistances en carbone - polymère (34, 40) imprimées sur le côté dos (4) de la carte de circuit imprimé (1).

2. Carte de circuit imprimé selon la revendication 1, **caractérisée en ce que**
les résistances en carbone - polymère (34, 40) imprimées sur le côté dos (4) sont recouvertes de laque d'arrêt de soudure (46).

3. Carte de circuit imprimé selon la revendication 1 ou 2, **caractérisée par**
des éléments de composant électroniques logés (48) sur le côté composant (10).

4. Appareil de commande, en particulier pour un véhicule, comportant une carte de circuit imprimé (1) selon l'une des revendications précédentes et un corps de refroidissement (6) avec lequel le côté dos (4) est en contact de manière thermoconductrice pour refroidir la carte de circuit imprimé (1), dans lequel le puits de chaleur (8) présente ledit corps de refroidissement (6).

5. Appareil de commande selon la revendication 4, **caractérisé par**
un boîtier (52), dans lequel la carte de circuit imprimé (1) est disposée et qui présente le corps de refroidissement (6) .

6. Appareil de commande selon la revendication 4 ou 5, **caractérisé en ce que**
la carte de circuit imprimé (1) est collée de manière thermoconductrice et électriquement isolante avec le corps de refroidissement (6).

7. Installation, en particulier pour un véhicule, comportant un appareil de commande (50) selon l'une des revendications 4 à 6 et un dispositif pouvant être électriquement commandé par l'appareil de commande (50), qui présente un boîtier de dispositif avec lequel le côté dos (4) est en contact de manière thermoconductrice pour refroidir la carte de circuit imprimé (1).

8. Véhicule comportant un appareil de commande (50) selon l'une des revendications 4 à 6 ou une installation selon la revendication 7.

9. Procédé de fabrication d'une carte de circuit imprimé (1) qui comporte un côté composant (10) et un côté dos (4) opposé au côté composant (10) et dont la surface est conçue de manière sensiblement plane de telle sorte que le côté dos (4) est en contact de manière thermoconductrice avec un puits de chaleur (8) pour refroidir la carte de circuit imprimé (1), en particulier sur une surface de contact sensiblement plane, dans lequel des moyens de refroidissement (12) pour refroidir le côté composant (10) vers le côté dos (4), présentant des microvias (14, 16, 20, 22) et des vias enterrés (28), sont aménagés dans la carte de circuit imprimé (1) à fabriquer, dans lequel plusieurs des microvias (14, 16) relient de manière thermoconductrice le côté composant (10) à une couche interne conductrice (30) de la carte de circuit imprimé (1) et d'autres microvias (20, 22) relient de manière thermoconductrice le côté dos (4) à une autre couche interne conductrice (32) de la carte de circuit imprimé (1) et deux couches internes conductrices (30, 32) sont reliées l'une à l'autre de manière thermoconductrice par l'intermédiaire des vias enterrés (28) disposés dans une couche interne isolante (26), **caractérisé en ce que**
des résistances en carbone - polymère (34, 40) sont imprimées sur le côté dos (4) de la carte de circuit imprimé (1) à fabriquer.

10. Procédé selon la revendication 9, **caractérisé en ce que**
les résistances en carbone - polymère (34, 40) sont recouvertes de laque d'arrêt de soudure (46).

11. Procédé selon la revendication 9 ou 10, **caractérisé en ce que**
des éléments de composant électroniques logés (48) sont disposés sur le côté composant (10).

12. Procédé de fabrication d'un appareil de commande (50), en particulier pour un véhicule, dans lequel une carte de circuit imprimé (1) est fabriquée au moyen d'un procédé selon l'une des revendications 9 à 11 et le côté dos (4) est mis en contact de manière thermoconductrice avec un corps de refroidissement (6) que présente le puits de chaleur (8), de telle sorte que la carte de circuit imprimé (1) peut être refroidie par le biais du côté dos (4) vers le puits de chaleur (8).

13. Procédé selon la revendication 12, **caractérisé en ce que**
la carte de circuit imprimé (1) est disposée dans un boîtier (52), qui présente le corps de refroidissement (6).

14. Procédé selon la revendication 12 ou 13, **caractérisé en ce que**
la carte de circuit imprimé (1) est collée de manière thermoconductrice et isolée électriquement avec le corps de refroidissement (6).

15. Procédé de fabrication d'une installation, en particulier pour un véhicule, dans lequel un appareil de commande (50) de ladite installation est fabriqué au moyen d'un procédé selon l'une des revendications 12 à 14, et le côté dos (4) est mis en contact de manière thermoconductrice avec un boîtier de dispositif d'un dispositif de l'installation pouvant être commandé électriquement par l'appareil de commande (50) pour refroidir la carte de circuit imprimé (1).
